# FASCICULE DE BREVET EUROPEEN

(11) **EP 0 426 077 B1**
(45) Date de publication et mention de la délivrance du brevet: **18.01.1995**
(21) Numéro de dépôt: 90120720.9
(22) Date de dépôt: 29.10.1990
(51) Int. Cl.: H01L 39/24, H01L 39/14

(54) **Procédé de réalisation d'une liaison de faible résistance électrique entre un métal et une céramique supraconductrice HTC**
Verfahren zur Herstellung einer widerstandsarmen Verbindung zwischen einem Metall und einem keramischen supraleitenden HTS
Process for making a low-resistant connection between a metal and a ceramic superconducting HTSC

(30) Priorité: 03.11.1989 FR 8914432
(43) Date de publication de la demande: 08.05.1991
(73) Titulaire: GEC ALSTHOM SA, 75116 Paris (FR)
(72) Inventeur: Leriche, Albert, F-75014 Paris (FR); Duperray, Gérard, F-91290 La Norville (FR); Grivon, Fernand, F-91240 Saint Michel Sur Orge (FR)
(74) Mandataire: Weinmiller, Jürgen

(56) Documents cités:
- EP-A- 0 292 126
- IEEE TRANSACTIONS ON MAGNETICS, vol. 25, no. 2, mars 1989, pp. 2056-2059, New York, US ; & APPLIED SUPERCONDUCTIVITY CONFERENCES, août 1988, US; J.MORELAND et al.: "Ag screen contacts to sintered YBa2Cu3Ox powder for rapid superconductor characterization"
- JAPANESE JOURNAL OF APPLIED PHYSICS, vol. 28, no. 10, octobre 1989, pp. L1740-L1741, Tokyo, JP; N. MURAYAMA et al.: "Joining of hot-pressed Bi-Pb-Sr-Ca-Cu-O superconductor"
- PATENT ABSTRACTS OF JAPAN, vol. 140, no. 79 (E-0888), 14 février 1990 ; & JP-A-1 292 871

## Description

La présente invention concerne un procédé de réalisation d'une liaison de faible résistance électrique entre un métal et une céramique supraconductrice à haute température critique (HTC).

Le problème est de réaliser une liaison de faible résistance électrique entre un métal et une céramique supraconductrice, afin d'acheminer de forts courants à la température d'utilisation, sans perturber son état de résistance nulle. Ainsi, une telle liaison doit posséder une résistance surfacique inférieure à 10⁻¹⁰ Ω.m² pour une densité de courant la traversant de l'ordre de 10³ A/cm², ce qui est le cas d'une application aux descentes de courant.

Actuellement les contacts électriques performants, qui présentent une résistance de l'ordre de 10⁻¹⁰ Ω.m², et qui sont mis en oeuvre sur une céramique de type YBa₂ Cu₃ O_{7-δ}, sont réalisés en déposant une couche d'argent par pulvérisation cathodique sur des petites surfaces. Mais un tel dépôt d'argent ne présente pas assez d'adhérence pour permettre un raccordement solide et performant de la céramique avec un métal normal.

On connaît par l'article paru dans IEEE Transactions on Magnetics, vol. 25, n° 2, mars 1989, pages 2056-2059 "Ag Screen Contacts to Sintered YBa₂Cu₃Oₓ Powder for rapid Superconductor Characterization" un procédé selon lequel on prépare des pastilles de poudre de céramique sur les faces desquelles on applique un maillage de fils d'argent de diamètre 0,11 mm ou 0,30 mm. On comprime l'ensemble et on effectue un frittage.
On connaît également, par l'article paru dans Appl. Phys. Lett. 54(25), 19 juin 1989, page 2605 "Low-resistivity contacts to bulk high Tc superconductors", un procédé consistant à disposer dans un moule de la poudre de céramique, à introduire des fils d'argent de diamètre 0,125 mm orthogonalement à la couche de poudre, à recouvrir de poudre de céramique en laissant dépasser les fils, à comprimer et à cuire.

On constate que les deux procédés précédents sont délicats à mettre en oeuvre car les fils d'argent ne doivent pas être détériorés au moment de la compression. Par ailleurs les fils ne peuvent laisser passer que des courants faibles, de l'ordre de 5 ampères.

L'article précité de Appl. Phys. Letters propose aussi un autre procédé consistant à mettre dans un moule un mélange homogène de poudre de céramique et de poudre d'argent, à comprimer et à cuire à une température de 1030°C, dépassant la température du point de fusion de l'argent. Il se crée alors des bulles, des particules d'argent se dispersent, apparaissent à la surface de la pièce et définissent ainsi des contacts électriques. Le procédé rend très difficile la maîtrise de la géométrie de ces contacts.

La présente invention a pour but d'éviter ces inconvénients et de mettre en oeuvre un procédé industriel assurant une liaison solide avec la céramique.

La présente invention a pour objet un procédé de réalisation d'une liaison de faible résistance électrique entre un métal et une pièce en céramique supraconductrice HTC, ladite pièce étant fabriquée à partir de poudre de céramique que l'on introduit dans un moule, que l'on comprime et que l'on fritte, caractérisé par le fait que, dans ledit moule, on juxtapose à ladite poudre de céramique, sans le mélanger avec elle, au moins un volume de poudre d'argent ou d'or correspondant à la forme de ladite liaison et situé à l'endroit voulu, et qu'après la compression l'opération de frittage s'effectue sous atmosphère contenant de l'oxygène, à une température inférieure à la température de fusion de l'argent ou de l'or.

Selon une première variante de réalisation, ladite pièce doit avoir la forme d'une pastille ; on dépose dans le moule un premier volume de poudre d'argent formant une première couche d'argent, la poudre de céramique, et un second volume de poudre d'argent formant une seconde couche d'argent, l'ensemble étant comprimé à l'aide d'une presse et cuit. On obtient une pastille munie sur ses deux faces d'une couche d'argent d'épaisseur supérieure à 0,1 mm, par exemple de l'ordre de 0,2 à 0,5 mm.

Selon une seconde variante de réalisation, ladite pièce doit avoir la forme d'un barreau ou d'un tube ; on prévoit dans le moule deux volumes de poudre d'argent au niveau des extrémités dudit barreau ou dudit tube.

La présente invention a également pour objet une pièce en céramique munie de sa liaison électrique. Cette pièce en céramique peut être à base d'un composé de Bismuth, d'un composé de type Y.Ba.Cu.O., éventuellement dopé avec de l'argent ou de l'or dans une proportion inférieure à 20% en poids ; la pièce peut être également à base d'un mélange des composés précédents.

Grâce au procédé selon l'invention on dispose d'une liaison formée d'une couche d'argent ayant un bon accrochage avec la céramique. Ceci permet un soudage aisé avec un métal normal à l'aide d'une brasure tendre à base d'étain et de plomb.

D'autres caractéristiques et avantages de la présente invention apparaîtront au cours de la description suivante de modes de réalisation donnés à titre illustratif mais non limitatif.

Dans un premier exemple, on réalise une pastille en céramique YBa₂Cu₃O_{7-δ} présentant une épaisseur de 4 mm, une section de 1 cm², avec sur chacune de ses faces une couche d'argent de 0,5 mm.

Selon l'invention, et préalablement à l'opération de compactage, on dépose au fond du moule une couche de poudre d'argent, puis la poudre de céramique, puis une autre couche de poudre d'argent. On effectue la compression à l'aide d'une presse de manière habituelle. Cette pastille subit ensuite le traitement classique de frittage sous atmosphère contenant de l'oxygène, avec une température maximale de 930°C.

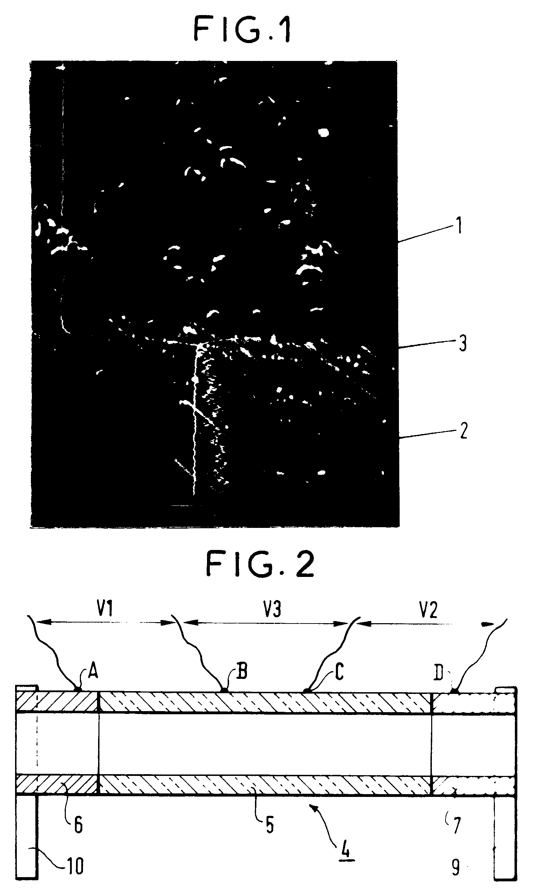

On voit dans la figure 1 une coupe partielle agrandie (x 1000) montrant la pastille de céramique supraconductrice 1 en Y.Ba.Cu.O avec sa couche d'argent 2. L'interface a été référencée 3. On voit que l'accrochage de la couche d'argent 2 s'est faite sans diffusion apparente de grains d'argent dans la céramique 1 et réciproquement. La tenue mécanique de la liaison est supérieure à celle de la céramique supraconductrice, à savoir 16 x 10⁶ Pascals.
A 77 K il n'y a pas de détérioration de l'interface.
La couche d'argent étant donc bien accrochée sur la céramique, elle peut être soudée avec du cuivre à l'aide d'une brasure tendre de type brasure à l'étain contenant 4 % d'argent. La résistance surfacique obtenue est de l'ordre de 10⁻¹¹ Ω.m² à 77 K et de 10⁻¹² Ω.m² à 4,2 K.

Dans un second exemple, on opère de la même manière pour réaliser un tube 4 visible en coupe longitudinale dans la figure 2.

La partie centrale 5 de ce tube 4 est obtenue à partir de 12 grammes d'un mélange de poudre de céramique de Y.Ba.Cu.O dopé d'argent à 10 %. Dans le moule on dispose d'abord un volume de 5 grammes de poudre d'argent correspondant à la liaison annulaire 6, puis le volume de poudre de céramique, puis un volume de 5 grammes de poudre d'argent correspondant à la liaison annulaire 7.

On effectue ensuite une compression isostatique sous 200 MPa, puis un frittage. Le traitement thermique a lieu sous air pendant 7 heures. Il comprend des rampes de température lentes (0,5°C par minute) et un palier de réoxydation de 15 heures vers 450°C.

Après le traitement le tube 4 présente les dimensions suivantes :
- Diamètre extérieur : 11,5 mm
- Diamètre intérieur : 8,9 mm
- Longueur : 60 mm.

Son courant critique de transport a été mesuré suivant la méthode dite des "4 points" référencés A, B, C, D. Une densité de courant critique de 720 A/cm² a été obtenue en appliquant le critère de 1 »v/cm. Dans ces conditions le champ magnétique créé à la surface de l'échantillon par le passage du courant est de 10 mTesla.

On a référencé sur le dessin :
- V₁ et V₂ qui sont les chutes ohmiques aux bornes des liaisons Argent-Céramique.
- V₃ qui est la chute ohmique de la céramique en cours de transition, l'intensité I étant l'intensité critique quand V₃ = 1 »V (distance BC = 1 cm).

Les valeurs de résistivité surfacique des liaisons Argent-Céramique sont reproductibles et relativement constantes entre 2 et 3 x 10⁻¹¹ Ω.m² lorsque le courant varie, jusqu'au voisinage de la densité de courant critique correspondant au point de transition du matériau supraconducteur. On voit dans la figure 2 que des reprises de courant 9 et 10 sont soudées directement sur les liaisons 6 et 7.

Le procédé selon l'invention est donc un procédé industriel qui permet une connexion solide entre la céramique et un métal sur des surfaces de plusieurs cm² avec une résistance de contact faible.

Bien entendu, l'invention n'est pas limitée aux modes de réalisation qui viennent d'être décrits. On pourra, sans sortir du cadre de l'invention, remplacer tout moyen par un moyen équivalent.

## Revendications

1. Procédé de réalisation d'au moins une liaison de faible résistance électrique entre un métal et une pièce en céramique supraconductrice à haute température critique, ladite pièce étant fabriquée à partir de poudre de céramique que l'on introduit dans un moule, que l'on comprime et que l'on fritte, caractérisé par le fait que, dans ledit moule, on juxtapose à ladite poudre de céramique, sans le mélanger avec elle, au moins un volume de poudre d'argent ou d'or correspondant à la forme de ladite liaison et situé à l'endroit voulu, et qu'après la compression l'opération de frittage s'effectue sous atmosphère contenant de l'oxygène à une température inférieure à la température de fusion de l'argent ou de l'or.

2. Procédé de réalisation selon la revendication 1, caractérisé par le fait que, ladite pièce ayant une forme de pastille, on dépose dans ledit moule un premier volume de poudre d'argent formant une première couche, puis la poudre de céramique supraconductrice, puis un second volume de poudre d'argent formant une seconde couche.

3. Procédé de réalisation selon la revendication 1, caractérisé par le fait que ladite pièce ayant la forme d'un tube ou d'un barreau, on prévoit dans ledit moule deux volumes de poudre d'argent respectivement au niveau des deux extrémités dudit tube ou dudit barreau.

4. Procédé de réalisation selon l'une des revendications précédentes, caractérisé par le fait que ladite céramique à haute température critique est choisie parmi les composés au bismuth, les composés de type Y-Ba-Cu-O, éventuellement dopés avec de l'argent ou de l'or dans une proportion inférieure à 20 % en poids, et leurs mélanges.

## Patentansprüche

1. Verfahren zur Herstellung einer niederohmigen Verbindung zwischen einem Metall und einem bei hoher kritischer Temperatur (HTC) supraleitenden Keramikteil, das ausgehend von Keramikpulver hergestellt wird, das man in eine Form bringt und dann komprimiert und sintert, dadurch gekennzeichnet, daß man in der Form neben dem Keramikpulver, ohne mit ihm vermischt zu werden, mindestens ein Volumen Silber- oder Goldpulver anordnet, das der Form der Verbindung entspricht und sich an der gewünschten Stelle befindet, und daß nach der Komprimierung der Sintervorgang in einer Sauerstoff enthaltenden Atmosphäre bei einer Temperatur durchgeführt wird, die unter der Schmelztemperatur des Silbers oder des Goldes liegt.

2. Herstellungsverfahren nach Anspruch 1, dadurch gekennzeichnet, daß das Teil die Form einer Tablette hat, und daß man auf den Boden einer Form ein erstes Volumen Silberpulver, das eine erste Schicht bildet, dann das supraleitende Keramikpulver und dann ein weiteres Volumen Silberpulver bringt, das eine zweite Schicht bildet.

3. Herstellungsverfahren nach Anspruch 1, dadurch gekennzeichnet, daß das Teil die Form eines Rohrs oder eines Stabs hat, und daß man in der Form zwei Volumen Silberpulver an je einem der beiden Enden des Rohrs oder des Stabs vorgesehen werden.

4. Herstellungsverfahren nach einem der vorhergehenden Ansprüche, dadurch gekennzeichnet, daß die Keramik mit hoher kritischer Temperatur aus Wismutzusammensetzungen, Zusammensetzungen der Art Y-Ba-Cu-O, eventuell dotiert mit Silber oder Gold in einem Anteil von weniger als 20 Gew.%, und ihren Mischungen ausgewählt wird.

## Claims

1. A method of making at least one low electrical resistance connection between a metal and a high critical temperature superconducting ceramic part, said part being made from a ceramic powder which is placed in a mold, compressed, and sintered, the method being characterized by the fact that at least one volume of silver or gold powder corresponding to the shape of said connection and situated at the desired location is placed inside said mold in juxtaposition with said ceramic powder but without being mixed therewith, after which the compression and the sintering are performed under an atmosphere containing oxygen and at a temperature that is lower than the melting temperature of silver or gold.

2. A method according to claim 1, characterized by the fact that said part is in the form of a pellet, and the following are placed in said mold: a first volume of silver powder forming a first layer, then the semiconducting ceramic powder, then a second volume of silver powder forming a second layer.

3. A method according to claim 1, characterized by the fact that said part is in the form of a tube or a rod, and two volumes of silver powder are provided in said mold at respective ones of the two ends of said tube or said rod.

4. A method according to any preceding claim, characterized by the fact that said high critical temperature ceramic is selected from compounds of bismuth, compounds of the Y-Ba-Cu-O type, optionally doped with not more than 20% by weight of silver or gold, and mixtures thereof.
